# EUROPEAN PATENT SPECIFICATION

(11) **EP 0 905 783 B1**
(45) Date of publication and mention of the grant of the patent: **14.06.2006**
(21) Application number: 98115567.4
(22) Date of filing: 19.08.1998
(51) Int. Cl.: H01L 27/108, H01L 21/8242

(54) **Vertical transistor implemented in a memory cell comprising a trench capacitor**
Vertikaler Transistor implementiert in einer Speicherzelle mit Grabenkondensator
Transistor vertical pour une cellule mémoire comprenant un condensateur à tranchée

(30) Priority: 30.09.1997 US 940649
(43) Date of publication of application: 31.03.1999
(73) Proprietor: Infineon Technologies AG, 81669 München (DE)
(72) Inventor: Alsmeier, Johann, Wappinger Falls, NY 12590 (US)
(74) Representative: Patentanwälte Westphal, Mussgnug & Partner

(56) References cited:
- EP-A- 0 282 716
- EP-A- 0 302 204
- EP-A- 0 463 389
- US-A- 5 164 917
- US-A- 5 252 845
- US-A- 5 395 786
- US-A- 5 477 071
- PATENT ABSTRACTS OF JAPAN vol. 011, no. 338 (E-553), 5 November 1987 & JP 62 118567 A (OKI ELECTRIC IND CO LTD), 29 May 1987
- PATENT ABSTRACTS OF JAPAN vol. 013, no. 445 (E-829), 6 October 1989 & JP 01 171266 A (MATSUSHITA ELECTRIC IND CO LTD), 6 July 1989
- PATENT ABSTRACTS OF JAPAN vol. 013, no. 280 (E-779), 27 June 1989 & JP 01 067966 A (MITSUBISHI ELECTRIC CORP), 14 March 1989

## Description

### Field Of Invention

The invention generally relates to devices and device fabrication and, more particularly, vertical transistor.

### Background Of Invention

In device fabrication, insulating, semiconducting, and conducting layers are formed on a substrate. The layers are patterned to create features and spaces. The minimum dimension or feature size (F) of the features and spaces depends on the resolution capability of the lithographic systems. The features and spaces are patterned so as to form devices, such as transistors, capacitors, and resistors. These devices are then interconnected to achieve a desired electrical function. The formation and patterning of the various device layers are achieved using conventional fabrication techniques, such as oxidation, implantation, deposition, epitaxial growth of silicon, lithography, and etching. Such techniques are described in S.M. Sze, VLSI Technology, 2nd ed., New York, McGraw-Hill, 1988.

Random access memories, such as dynamic random access memories (DRAMs), comprise memory cells that are configured in rows and columns to provide storage of information. One type of memory cell includes a transistor connected to, for example, a trench capacitor by a strap. Typically, the capacitor plate, which is connected to the transistor, is referred to as a "node". When activated, the transistor allows data to be read or written into the capacitor.

Continued demand to shrink devices have facilitated the design of DRAMs having greater density and smaller feature size and cell area. For example, reduction of the conventional cell area of 8F² towards and below 6F² have been investigated. However, the fabrication of such densely packed small feature and cell sizes becomes problematic. For example, mask level overlay sensitivity as a result of miniaturization causes difficulty in designing and fabricating the transistor in the DRAM cell. Additionally, such miniaturization has produced array devices scaled to its limits, resulting in short channel problems that adversely affect the operation of the cells. To further exacerbate the problem, short channel device design rules are contradictory to conventional low level doping of the node junctions.

From the above discussion, it is apparent that there is a need to provide a transistor that is easily implemented in a DRAM cell.

EP-A-0282716, titled "DRAM cell and method", discloses a method for forming DRAM cell by etching into insulating material and filling the opening with conductive material to form gate controlling conduction between source and drain regions.

EP-A-0302204, titled "Vertical trench transistor/capacitor memory cell structure and fabricationmethod therefor", relates to a memory cell having vertical trench transistor and trench capacitor manuufactured by self-alignment epitaxial growth, giving small wordline loading and reduced wordline-to-bit coupling capacitance.

JP 62 118567 A, titled "Semiconductor device and manufacture thereof",teaches a method for manufacturing an MOS type DRAM with large capacitance by forming a capacitor in a deep trench near the active region and growing a memory cell in the area at the side wall of the trench.

### Summary Of Invention

The invention relates to a vertical transistor incorporated in a memory cell having a trench capacitor as claimed in claim 1. The trench capacitor is formed in a substrate, such as a silicon wafer. The top surface of the trench capacitor is recessed below the top surface of the substrate. A shallow trench isolation (STI) is provided to isolate the memory cell from other devices. The STI overlaps a portion of the trench capacitor, leaving a remaining portion above the trench capacitor. Also, a transistor is located on the substrate opposite the STI. The transistor comprises a gate, drain, and source. The gate includes a conductive layer having a horizontal portion located above the surface of the substrate and a vertical portion wrapping into the remaining portion between the silicon sidewall and STI sidewall. The vertical portion of the transistor is isolated from the trench capacitor by a dielectric layer.

### Brief Description of Drawinqs

Fig. 1 shows a conventional DRAM cell;
Fig. 2 shows a DRAM cell in accordance with the invention; and
Figs. 3a-3i show the process for fabricating the DRAM cell of Fig. 2.
Figs. 4a-c show an alternative of the transistor, not part of the invention; and
Fig. 5 shows a computer system employing a memory chip in accordance with the invention.

### Detailed Description Of The Invention

The present invention relates to a vertical transistor. For purposes of illustration, the present invention is described in the context of fabricating a trench capacitor memory cell. The memory cell is employed in an integrated circuit. The IC is, for example, a random access memory (RAM), a dynamic random access memory (DRAM), or a synchronous DRAM (SDRAM). IC such as an application specific IC (ASIC), a merged DRAM-logic circuit (embedded DRAM), or any other logic circuit is also useful.

Typically, numerous ICs are formed on the wafer in parallel. After processing is finished, the wafer is diced to separate the ICs to individual chips. The chips are then packaged, resulting in a final product that is used in, for example, consumer products such as computer systems, cellular phones, personal digital assistants (PDAs), and other electronic products. However, the invention is significantly broader and extends to the fabrication of transistors in general.

To facilitate understanding of the invention, a description of a conventional trench capacitor DRAM cell is provided.

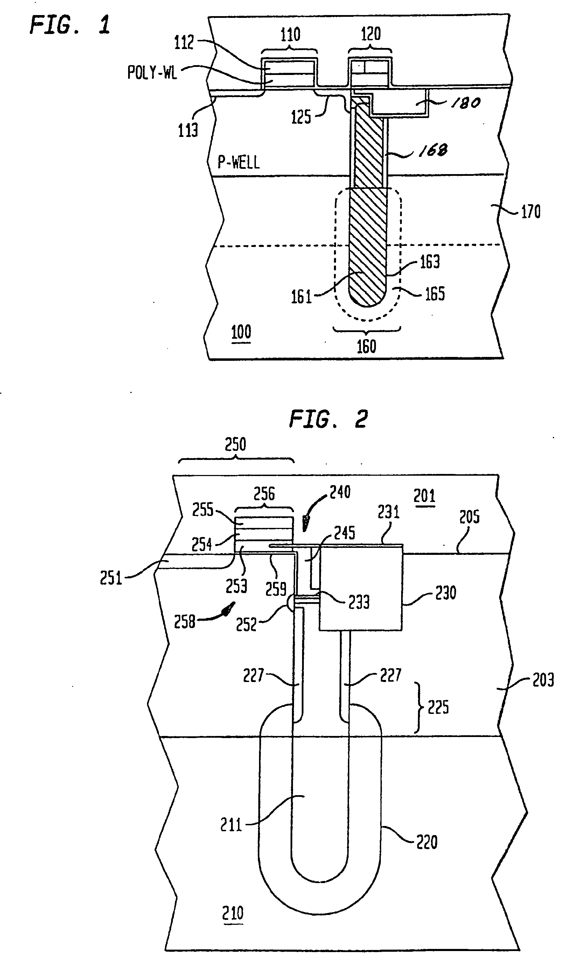

Referring to Fig. 1, a conventional trench capacitor DRAM cell 100 is shown. Such conventional trench capacitor DRAM cell is described in, for example, Nesbit et al., A 0.6 µm² 256Mb Trench DRAM Cell With Self-Aliqned Buried Strap (BEST), IEDM 93-627, Typically, an array of cells are interconnected by wordlines and bitlines to form a DRAM chip.

The DRAM cell comprises a trench capacitor 160 formed in a substrate 101. The substrate is lightly doped with p-type dopants (p⁻), such as boron (B). The trench is filled with, typically, polysilicon (poly) 161 heavily doped with n-dopants (n⁺), such as arsenic (As). The poly serves as one plate of the capacitor. The other plate of the capacitor is formed by a buried plate 165 doped with As.

The DRAM cell also comprises a horizontal transistor 110. The transistor includes a gate 112, source 113, and drain. The gate and source are formed by implanting n-type dopants, such as phosphorus (P). The designation of the source and drain may change depending on the operation of the transistor. For convenience, the terms source and drain are interchangeable. Connection of the transistor to the capacitor is achieved via a strap 125. The strap is formed by providing As dopants outdiffused from the As doped poly in the trench.

A collar 168 is formed at the top portion of the trench. The collar prevents punchthrough of the node junction to the buried plate. Punchthrough is undesirable as it affects the operability of the cell. As shown, the collar defines the bottom of the buried strap and the top of the buried plate.

A buried well 170 comprising n-type dopants, such as P, is provided below the surface of the substrate. The peak concentration of dopants in the buried n-well is at about the bottom of the collar. Typically, the well is lightly doped. The buried well serves to connect the buried plates of the DRAM cells in the array

Activation of the transistor by providing the appropriate voltages at the source and gate enables data to be written or read from the trench capacitor. Generally, the gate and source form a wordline and a bitline, respectively, in the DRAM array. A shallow trench isolation (STI) 180 is provided to isolate the DRAM cell from other cells or devices. As shown, a wordline 120, is formed over the trench and isolated therefrom by the STI. Wordline 120 is referred to as the "passing wordline". Such configuration is referred to as a folded bitline architecture.

Fig. 2 shows an exemplary embodiment of a vertical transistor 250 in accordance with the invention. The vertical transistor is implemented in a, DRAM cell 201. The DRAM cell is a merged isolation node trench (MINT) cell. Other cell configurations are also useful.

As shown, the DRAM cell employs a trench capacitor 210 formed in a substrate 203. The substrate, for example, is lightly doped with dopants having a first conductivity. In one embodiment, the substrate is lightly doped with p-type dopants (p⁻), such as B. Typically, the trench comprises poly 211 heavily doped with dopants having a second conductivity. As shown, the poly is heavily doped with n-type dopants (n⁺) such as, for example, As or P. In one embodiment, the poly is heavily doped with As. The poly 211 serves as one plate of the capacitor. The other plate of the capacitor is formed by a n-type buried plate 220 comprising, for example, As.

A collar 227 is provided near the top of the trench and extends slightly below the top of the buried plate. The collar is sufficiently thick to prevent punchthrough from the node junction to the buried plate. In one embodiment, the collar is about 20-40 nm. A n-type buried well 225 comprising, for example, P dopants is provided at about the bottom of the collar 227. The buried well connects the buried plates of the other DRAM cells in the array together.

Illustratively, the vertical transistor 250 is a n-channel transistor. The transistor comprises a gate stack 256, source 251, and drain 252. The gate stack, also referred to as the "wordline", typically includes conductive 253 and nitride 255 layers. The conductive layer 253, in one embodiment, is a poly layer. Alternatively, the conductive layer is a polycide layer to reduce the resistance of the wordline. The polycide layer comprises a silicide layer on top of a poly layer. Various silicides, including molybdenum (MoSix), tantalum (TaSix), tungsten (WSix), titanium (TiSix) or cobalt (CoSix) are useful to form the silicide layer. Aluminum or refractory metals, such as tungsten and molybdenum, may also be used alone or in combination with silicides to form the conductive layer.

A portion 245 of the gate comprising poly extends beyond the edge of the gate stack 256 aligned to the active edge for a 6F² cell layout and into the upper portion of the trench. A dielectric layer 233 located below the portion 245 of the gate is provided. The dielectric layer is sufficiently thick to isolate portion 245 from the node. In one embodiment, the isolation layer comprises a dielectric material such as oxide formed by, for example, high density plasma deposition or flowable oxide.

Underneath the gate is a gate oxide 259. The gate oxide extends from underneath the gate stack 256 to the opposite side of the source 251 and wraps around the sidewall of the substrate, extending towards the isolation layer 233. The drain is located in the silicon substrate adjacent to the wrap around portion of the gate oxide. The drain and source comprise appropriate dopant profiles to achieve the desired electrical characteristics.

In accordance with the invention, the gate comprises a horizontal portion 256 and a vertical portion 245. The portion 245, which is perpendicular to the horizontal portion, extends vertically below the surface of the substrate above the trench 210. By having a vertical portion 245, the length of the device can be extended without increasing surface area. For example, the length of the device can be increased by forming the vertical portion deeper into the substrate. Therefore, the vertical transistor avoids the problems associated with short channel effect.

As shown, the dielectric layer 233 is separated from the collar. The separation is large enough to allow sufficient current to flow from the node to the drain, thus providing the connection between the transistor and the capacitor. The drain is formed by outdiffusing As from the trench poly.

To isolate the DRAM cell from other DRAM cells in the array a STI 230 is provided. In one embodiment, a top surface 231 of the STI is raised above the plane of the silicon substrate surface 205. Alternatively, a non-raised STI is also useful. Raised STI (RSTI) is described in US patent titled Reducing Oxidation Stress In The Fabrication Of Devices (US 5,867,420). As stated therein, the top surface of the RSTI is raised above the substrate surface sufficiently to effectively reduce the formation of divots extending below the silicon substrate surface. Formation of divots below the silicon substrate surface adversely affects the operability of the DRAM cells in the array. In one embodiment, the distance that the top surface of the RSTI is raised is ≤ about 100 nm. Preferably, the distance is about 20 - 100 nm, more preferably about 40 - 80 nm, and even more preferably about 50 - 70 nm. In another embodiment, the distance that the top surface of the RSTI is raised is about 50 nm. A STI having a top surface substantially planar with the surface of the silicon substrate is also useful.

Above the RSTI, a thin layer of oxide 240 is provided. The oxide extends into a portion of the poly 213 of the gate stack. The oxide serves as an etch stop for the etch that forms the gate stack. The oxide extends into the gate stack sufficiently to prevent gate stack etch from etching into portion 245 of the gate. In one embodiment, the oxide extends nominally about 1/3 the width of the gate.

A passing wordline (not shown) is formed above the RSTI. The passing wordline is isolated from the trench by the RSTI oxide. In one embodiment, one edge of the passing wordline is aligned with the trench sidewall that is opposite of the sidewall with which the gate 256 is aligned and extends away from gate 256. Such configuration is referred to as a 6F² layout supporting an open-folded bitline architecture. Other configuration such as, for example, folded or open architecture is also useful.

Illustratively, the first conductivity is p-type and the second conductivity is n-type. However, forming the DRAM cell in a n-type substrate with p-type poly filled trench is also useful. Further, it is possible to heavily or lightly doped the substrate, wells, buried plate, and other elements of the DRAM cell with impurity atoms to achieve the desired electrical characteristics

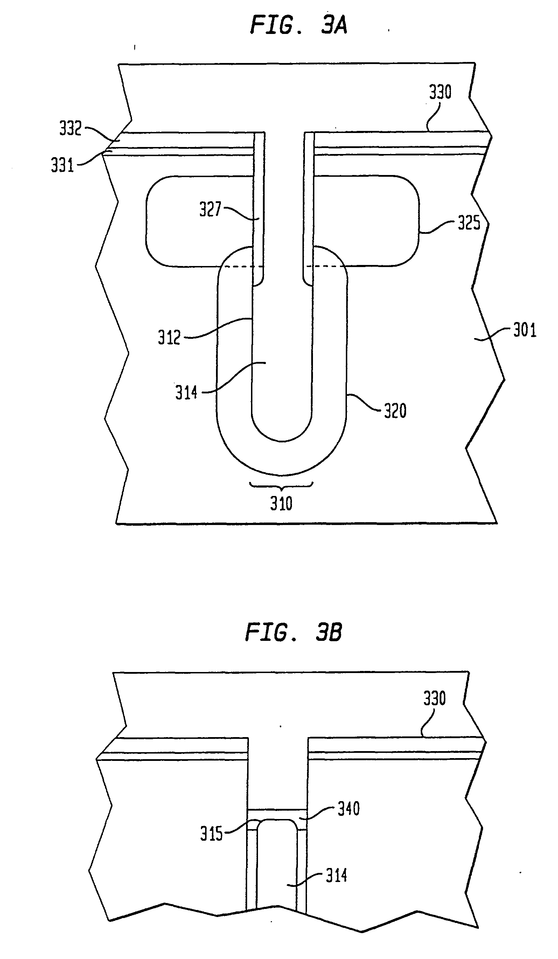

Figs. 3a-g show the process for forming the vertical transistor implemented in a DRAM cell comprising a trench transistor and a RSTI. Referring to Fig. 3a, a trench capacitor 310 is formed in a substrate 301. The major surface of the substrate is not critical and any suitable orientation such as a (100), (110), or (111) is useful. In an exemplary embodiment, the substrate is a silicon wafer that has been lightly doped with p-type dopants (p<->), such as B. Typically, a pad stack 330 is formed on the surface of the substrate. The pad stack comprises, for example, a pad oxide layer 331, a polish stop layer 332, and a hard mask layer (not shown). The polish stop layer comprises, for example, nitride and the hard mask comprises TEOS. Other materials, such as BPSG or BSG, are also useful for the hard mask layer.

The trench capacitor 310 is formed in the substrate by conventional techniques. Such techniques are described in, for example, Mller et al., Trench Storage Node Technology for Gigabit DRAM Generations, IEDM 96-507, As shown, the trench is filled with poly 314 that has been heavily doped with As dopants. The doped poly serves as one plate of the capacitor. A buried plate 320 comprising of As dopants surrounds the bottom portion of the trench and serves as the other plate of the capacitor. The trench and buried plate are isolated from each other by a node dielectric layer 312. In one embodiment, the node dielectric layer comprises nitride and oxide layers. In an upper portion of the trench, a collar 327 is formed. The collar comprises a dielectric material such as, for example, TEOS. Additionally, a n-type well 325 lightly doped with P. dopants is provided for interconnecting the buried plates of the DRAM cells in the array together.

As shown in Fig. 3a, the surface of the substrate have been polished by, for example, chemical mechanical polishing (CMP). The nitride layer 332 serves as a CMP stop layer, causing the CMP to stop once it reaches the nitride layer. As a result, the poly that covers the surface of the substrate is removed, leaving a substantially planar surface between the nitride layer 332 and trench poly 314 for subsequent processing.

Referring to Fig. 3b, the formation of the strap for connecting the trench to the transistor of the DRAM cell is shown. The doped poly 314 in the trench is recessed, by for example, reactive ion etching (RIE) to a depth sufficient to accommodate the length of the vertical transistor. In one embodiment, the poly is recessed to about 200-500 nm below the silicon surface. Preferably, the poly is recessed to about 300-400 nm below the silicon surface, more preferably to about 350 nm. After the trench is recessed, the sidewalls of the trench are cleaned for subsequent processes. Cleaning the sidewalls also recesses the collar below a top surface 315 of the doped poly 314. This results in a gap between the silicon and poly sidewalls.

A poly layer is deposited on the substrate, covering the nitride layer 330 and top portion of the trench. Typically, the poly layer is an intrinsic (undoped) poly layer. The poly layer is planarized down to the nitride layer 232. After planarization, the poly in the trench is recessed to, for example, about 300 nm below the surface of the substrate, leaving a strap 340 of about 50 nm thick above the doped poly 314.

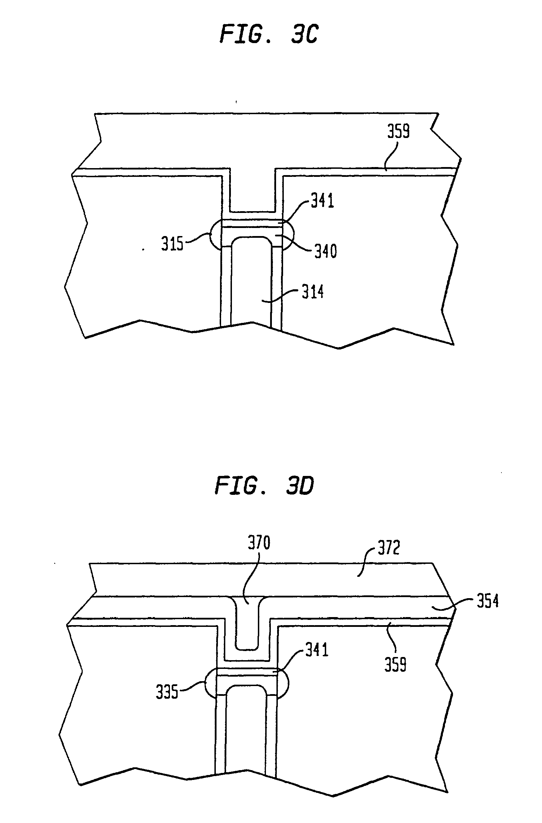

Referring to Fig. 3c, a dielectric layer 341 such as oxide is formed over the surface of the substrate and the strap 340. The oxide layer is, for example, a nonconformal layer formed by high density chemical vapor deposition (HDCVD) other techniques, such as spin on and anneal of a flowable oxide, are also useful. The oxide layer is sufficiently thick to isolate the gate of the transistor that is to be formed in the upper portion of the trench above. In one embodiment, the oxide layer is about 50 nm thick.

The pad nitride and oxide layers are then removed. First, the pad nitride layer is removed by, for example, wet chemical etch. The wet chemical etch is selective to oxide. To ensure that the nitride layer is completely removed, an overetch is employed. Next, the pad oxide is removed by wet chemical etch selective to silicon. The removal of the pad oxide removes only a defined amount of the oxide layer 341.

Subsequently, an oxide (not shown) layer is then formed on the surface of the wafer. The oxide layer, referred to as a "gate sacrificial layer", serves as a screen oxide for subsequent ion implantation

To form the p-type well region for the n-channel access transistor of the DRAM cell, a resist layer (not shown) is deposited on top of the oxide layer and appropriately patterned to expose the p-type well region. P-type dopants, such as B, are implanted into the well region. The dopants are implanted sufficiently deep to prevent punchthrough. The dopant profile is tailored to achieve the desired electrical characteristics, such as gate threshold voltage (Vₜ). The thermal budget on the well dopants due to subsequent processes are taken into account when designing the dopant profiles.

In addition, p-type wells for n-channel support circuitry are also formed. For complimentary wells in complimentary metal oxide silicon (CMOS) devices, n-type wells are formed. Formation of n-type wells requires additional lithographic and implant steps for defining and forming the n-type wells. As with the p-type wells, the profile of the n-type wells are tailored to achieve the desired electrical characteristics.

After the implants, the gate sacrificial layer is removed. A gate oxidation layer 359 is then formed. The various high ntemperature process steps causes As dopants from the doped poly 314 in the trench to diffuse through the strap 340 to form the drain 335. The thermal budget of the subsequent processes are taken into account to tailor the dopant profile of the drain.

Referring to Fig. 3d, a poly layer 354 is deposited over the gate oxide layer 359. The poly layer serves as the lower portion of the conductive layer of the gate stack. In one embodiment, the thickness of the poly layer is about 20 - 70 nm, preferably about 30 nm. The poly layer is conformal to the topography of the substrate surface. As such, a hole 370 is created above the trench. A dielectric layer is then formed over the poly layer to sufficiently fill the void. The dielectric layer comprises, for example, an oxide layer. Nitride is also useful to fill the void. The horizontal surface of the dielectric layer is removed by polishing selective to poly, leaving the void above the trench filled with oxide.

Next, a nitride layer 372 is formed over the poly layer. The nitride layer is sufficiently thick to serve as an polish stop for subsequent processes. Typically, the thickness of the nitride layer is about 50 - 100 nm (500-1000 Å).

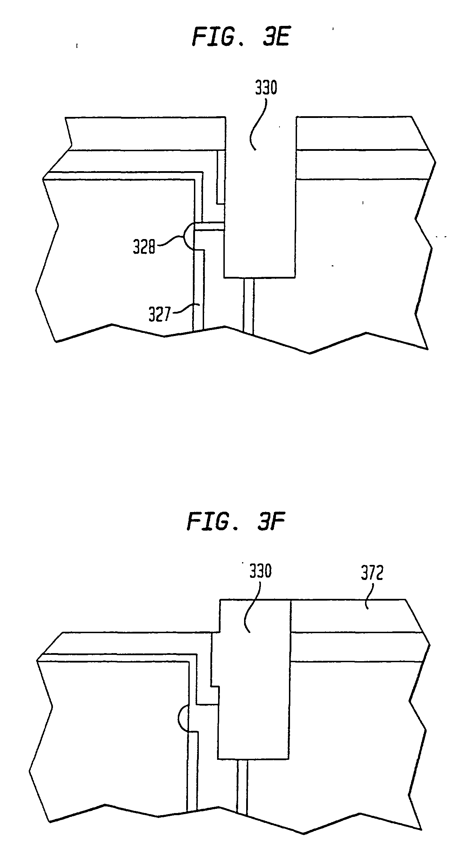

Fig. 3e shows the process for defining and forming the RSTI region of the DRAM cell. As shown, the RSTI region overlaps a portion of the trench, leaving a remaining portion to permit a sufficient amount of current to flow between the transistor and capacitor. In one embodiment, the RSTI overlaps ≤ about half the trench width, preferably about half the trench width.

Defining the STI region 330 is achieved with conventional lithographic techniques. After the RSTI region is defined, it is anisotropically etched by, for example, RIE. The RSTI region is etched sufficiently deep to isolate the buried strap 340 from the silicon sidewall opposite the side where the transistor of the DRAM cell is to be formed. As shown, the RSTI region is etched to a depth that is below the top 328 of the collar 327. In one embodiment, the RSTI region is etched about 450 nm below the silicon surface.

Referring to Fig. 3f, a dielectric material such as, for example, TEOS is deposited on the surface of the substrate to sufficiently fill the RSTI region 330. The TEOS is deposited by high density plasma (HDP) deposition. In one embodiment, a thin oxide layer is first formed on the surface of the substrate by, for example, rapid thermal oxidation (RTO). A thicker layer of oxide, such as TEOS is then deposited (HDP)over the RTO oxide layer. The TEOS is sufficiently thick to fill the RSTI. The TEOS, for example, is about 500-600 nm (5000-6000 Å) thick. Forming a thin oxide layer to serve as a seed oxide layer for the thicker TEOS layer reduces stress during the TEOS growth.

Since the TEOS layer is conformal, planarization schemes such as, for example, maskless STI planarization are employed. The excess TEOS is removed by RIE and polished so that the top surface of the RSTI is planar with the surface of the nitride layer 372. Typically, the RSTI oxide is densified to improve subsequent wet etch selectivity. Densification of the RSTI oxide is done by, for example, annealing.

In Fig. 3g, the nitride layer is removed. During the removal of the nitride, a portion of the RSTI oxide is also removed, leaving the top surface of the RSTI substantially planar with the top surface of the poly layer 354. An oxide layer is then formed over the substrate and patterned to form oxide 340. The oxide typically is located over the RSTI 330 and extends pass the edge of the trench sidewall on the side where the transistor is formed to serve as an etch stop for the gate stack etch. The oxide 340 prevents the gate stack etch from etching into the portion 351 of the poly in the top of the trench. In one embodiment, the oxide 340 extends beyond the trench sidewall a distance that is nominally about 1/3 the width of the gate.

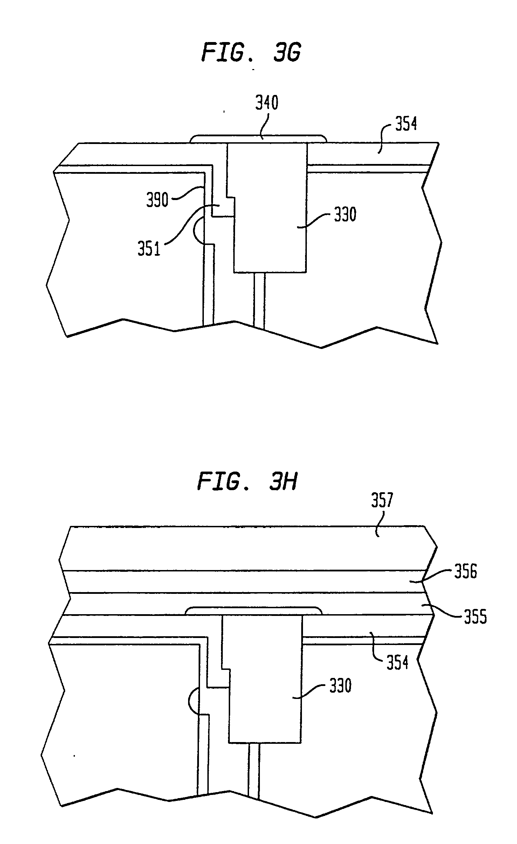

Referring to Fig. 3h, various layers forming the gate stack are formed over poly 354 and oxide 340. As shown, a poly layer 355 is formed over the poly layer 354. Poly layer 355 is used to form the upper portion of conductive layer in the gate stack. Optionally, a silicide layer comprising, for example, WₓSi is formed to produce a composite gate stack to lower the wordline resistance. The combined thickness of the layers 353 and 354 are sufficient to formed the conductive layer of the gate. Of course, this thickness may vary depending on design specifications. In one embodiment, the thickness of the combined layers is about 50-100 nm. A nitride layer 357 is formed above layer 355. The nitride layer serves as an etch stop for forming a boarderless bitline contact.

In Fig. 3i, the surface of the substrate is patterned to form a gate stack for a transistor 380 of the DRAM cell. A passing gate stack 370 is typically formed over part of the RSTI and isolated therefrom by the RSTI oxide. Source 381 is formed by implanting or outdiffusing dopants having the appropriate profile to achieve the desired operating characteristics. In the illustrative embodiment, P dopants are implanted to form the source. To improve diffusion and alignment of the source to the gate, nitride spacers (not shown) may be employed.

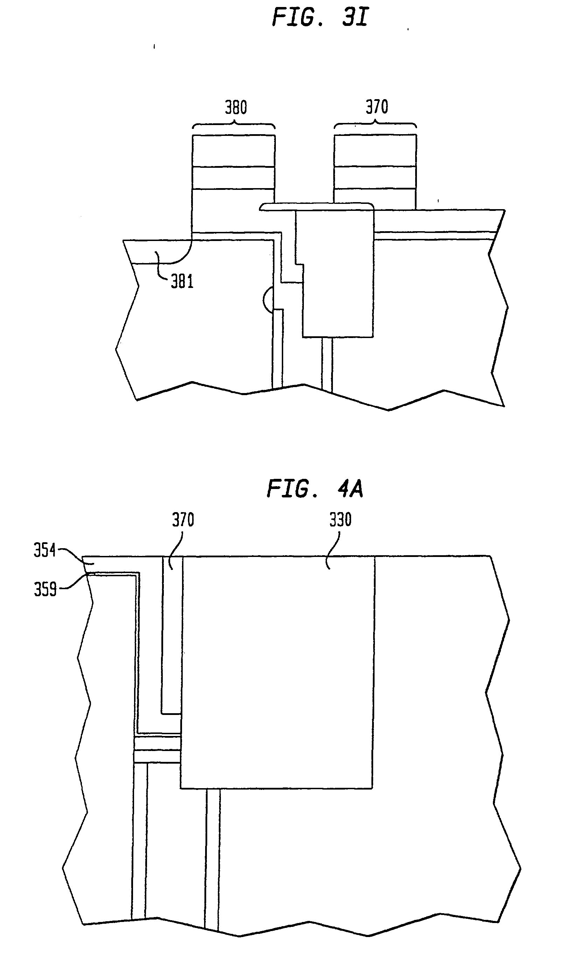

Figs. 4a-c show a process for forming an alternative transistor, not part of the invention. Referring to Fig. 4a, a partially formed trench capacitor memory cell with a vertical transistor is shown. Up to this point, the cell is formed in the manner as discussed from Figs 3a-f. The nitride layer is removed by, for example, CMP selective t poly. During the removal of the nitride, a portion of the RSTI oxide 330 is also removed, leaving the top surface of the RSTI substantially planar with the top surface of the poly layer 354.

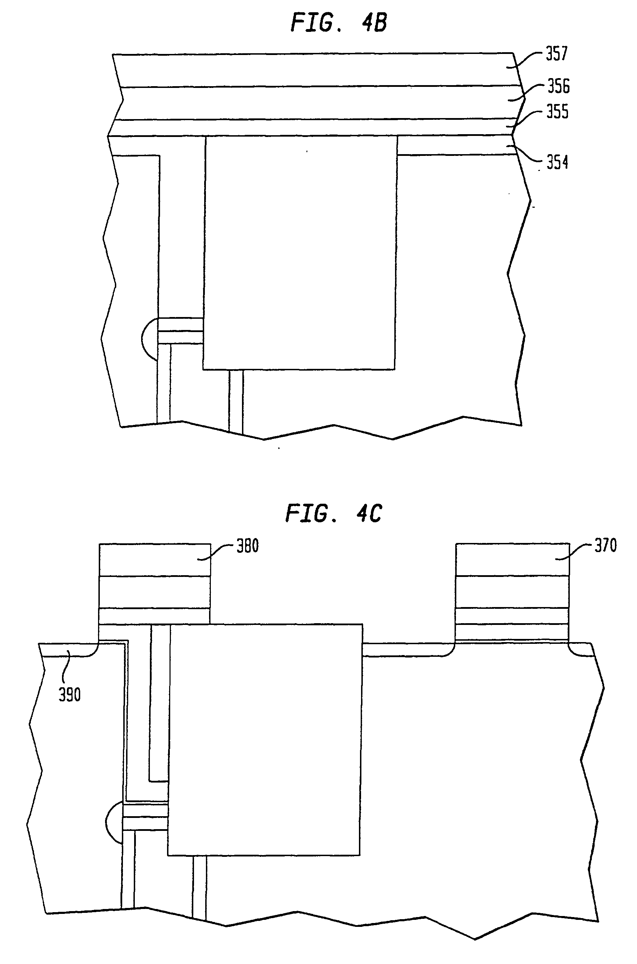

Referring to Fig. 4b, various layers forming the gate stack are formed over poly 354 and oxide 340. As shown, a poly layer 355 is formed over the poly layer 354. Poly layer 355 is used to form the upper portion of conductive layer in the gate stack. Optionally, a silicide layer comprising, for example, WxSi is formed to produce a composite gate stack to lower the wordline resistance. The combined thickness of the layers 353 and 354 are sufficient to form the conductive layer of the gate. Of course, this thickness may vary depending on design specifications. In one embodiment, the thickness of the combined layers is about 50-100 nm. A nitride layer 357 is formed above layer 355. The nitride layer serves as an etch stop for forming a boarderless bitline contact.

In Fig. 4c, the surface of the substrate is patterned to form a gate stack for a transistor 380 of the DRAM cell. The gate stack, as shown, overlays the RSTI on one side and the substrate surface 390 on the other. Since the gate stack width is typically equal to about F, the gate overlay is about 1/3 F. A gate stack 370 for support device or other device is also formed. Diffusion regions for the devices are formed by implanting or outdiffusing dopants having the appropriate profile to achieve the desired operating characteristics.
In the illustrative embodiment, P dopants are implanted to form the source. To improve diffusion and alignment of the source to the gate, nitride spacers (not shown) may be empl,oyed.

Thereafter, processing is continued to complete the formation of the IC. This, for example, includes forming mult-level metallization separated by inter-level dielectic, contacts to achieve the desired function, hard and soft passivation layers, and packaging.

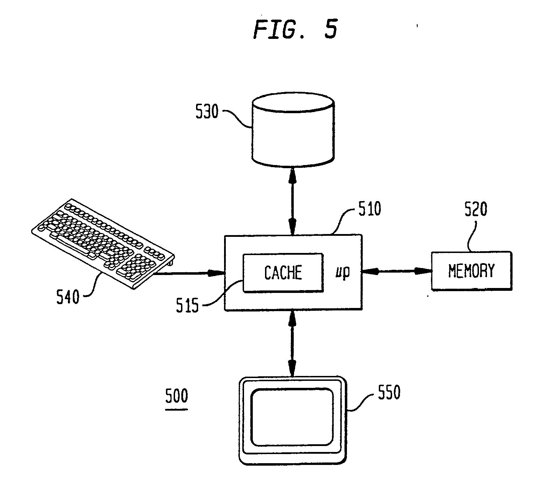

Referring to Fig. 5, a typical computer system 500 is shown. As shown, the system includes a processor 510 which, for example, is a microprocessor such as those produced by Intel. The processor performs arithmetical and logical operations as provided by the processor's instruction set. Computer programs and data are stored in the computers memory storage 530. The memory storage includes magnetic or optical memory storage elements.

A keyboard 540 is provided to input commands to the system, as desired by a user. Other input device such as a mouse for inputting instructions by "point and click" technique may also be provided. The command, for example, executes a computer program stored in the computer's storage. The computer program is then loaded into the computer's memory or RAM. The RAM includes DRAM ICs such as those described in the invention. Data stored in a data file located in the computer's storage and which is required for the execution of the computer program is also transferred to the computer's RAM. Additionally, the user inputs data as required or desired, via the input device or devices.

Portion of the data and computer program that are recently or often used are stored in the computer's high speed memory 415 known as the "cache". The cache, illustratively, is part of the processor. The results of the program are then provided to the user via a display 550.

While the invention has been particularly shown and described with reference to various embodiments, it will be recognized by those skilled in the art that modifications and changes may be made to the present invention without departing from the scope thereof. Merely by way of example, the illustrative embodiments of the invention have been described with specific dimensions. These dimensions, however, are exemplary and may vary according to specific applications.

## Claims

1. A random access memory cell comprising
• a trench capacitor (210) formed in a substrate (203), wherein a top surface of the trench capacitor (210) is recessed below a top surface of the substrate (203);
• a shallow trench isolation (STI), the STI overlapping a portion of the trench capacitor (210) so as to leave exposed a remaining portion of the trench above the trench capacitor (210), and
• a transistor (250) located on the substrate (203) and on said exposed remaining portion of the trench opposite the STI (230), the transistor comprising a gate, drain (252), and source (251),
• the gate comprising a first conductive layer having a horizontal portion (253) located above the surface of the substrate (203) and a vertical portion (245) wrapping into said remaining portion of the trench below the surface of the substrate (210) and above the trench capacitor (210),
• a dielectric layer (233) located above the trench capacitor (210) to isolate the vertical portion (245) of the conductive layer of the gate from the trench capacitor (210),
**characterized in that**
• a channel of said transistor (250) includes first and second regions, the first region being parallel to the top surface of the substrate (203) and the second region being perpendicular to the first region;
• the gate further comprises a gate stack (254+255) aligned to the edge of the trench and overlying the horizontal portion of the first conductive layer (253) of the gate; and
• an oxide layer (231; 340) extends above said STI (230) and over a portion of the horizontal portion of the first conductive layer (253) of the gate, and under a corresponding portion of the gate stack.

2. A random access memory cell according to claim 1, wherein said oxide layer (240) extends nominally about 1/3 the width of the gate.

3. A computer system comprising a memory using the memory cell according to claims 1 and 2.

## Patentansprüche

1. Zugriffsspeicherzelle, umfassend:
• einen Grabenkondensator (210), der in einem Substrat (203) ausgebildet ist, wobei eine obere Oberfläche des Grabenkondensators (210) unter eine obere Oberfläche des Substrats (203) ausgenommen ist;
• eine flache Grabenisolierung (STI), wobei die STI einen Abschnitt des Grabenkondensators (210) überlappt, um einen verbleibenden Abschnitt des Grabens über dem Grabenkondensator (210) exponiert zu lassen, und
• einen Transistor (250), der auf dem Substrat (203) und auf dem exponierten verbleibenden Abschnitt des Grabens gegenüber der STI (230) liegt, wobei der Transistor eine Gateelektrode, eine Drainelektrode (252) und eine Sourceelektrode (251) umfaßt,
• wobei die Gatelektrode eine erste leitende Schicht mit einem über der Oberfläche des Substrats (203) liegenden horizontalen Abschnitt (253) und einem sich in den verbleibenden Abschnitt des Grabens unter der Oberfläche des Substrats (210) und über dem Grabenkondensator (210) wickelnden vertikalen Abschnitt (245) umfaßt,
• eine über dem Grabenkondensator (210) liegende dielektrische Schicht (233) zum Isolieren des vertikalen Abschnitts (245) der leitenden Schicht der Gateelektrode von dem Grabenkondensator (210),
**dadurch gekennzeichnet, daß**
• ein Kanal des Transistors (250) ein erstes und zweites Gebiet enthält, wobei das erste Gebiet parallel zur oberen Oberfläche des Substrats (203) und das zweite Gebiet senkrecht zum ersten Gebiet verläuft;
• die Gatelektrode weiterhin einen auf den Rand des Grabens ausgerichteten und über dem horizontalen Abschnitt der ersten leitenden Schicht (253) der Gateelektrode liegenden Gatestapel (254+255) umfaßt und
• sich eine Oxidschicht (231; 340) über der STI (230) und über einen Abschnitt des horizontalen Abschnitts der ersten leitenden Schicht (253) der Gateelektrode und unter einen entsprechenden Abschnitt des Gatestapels erstreckt.

2. Direktzugriffsspeicherzelle nach Anspruch 1, wobei sich die Oxidschicht (240) nominell über etwa 1/3 der Breite der Gateelektrode erstreckt.

3. Computersystem, umfassend einen Speicher, der die Speicherzelle nach den Ansprüchen 1 und 2 verwendet.

## Revendications

1. Cellule de mémoire vive, comprenant :
un condensateur à tranchée (210) formé dans un substrat (203), dans lequel une surface supérieure du condensateur à tranchée (210) est évidée en dessous d'une surface supérieure du substrat (203) ;
une isolation de tranchée peu profonde (STI), la STI chevauchant une partie du condensateur à tranchée (210) de manière à laisser une partie restante de la tranchée exposée au-dessus du condensateur à tranchée (210), et
un transistor (250) situé sur le substrat (203) et sur la partie restante exposée de la tranchée opposée à la STI (230), le transistor comprenant une porte, un drain (252), et une source (251),
la porte comprenant une première couche conductrice ayant une partie horizontale (253) située au-dessus de la surface du substrat (203) et
une partie verticale (245) s'enroulant dans la partie restante de la tranchée en dessous de la surface du substrat (210) et au-dessus du condensateur à tranchée (210),
une couche diélectrique (233) située au-dessus du condensateur à tranchée (210) pour isoler la partie verticale (245) de la couche conductrice de la porte par rapport au condensateur à tranchée (210),
**caractérisée en ce que**
un canal du transistor (250) comprend des première et deuxième régions, la première région étant parallèle à la surface supérieure du substrat (203) et la deuxième région étant perpendiculaire à la première région ;
la porte comprend en outre une pile de portes (254 + 255) alignée par rapport au bord de la tranchée et recouvrant la partie horizontale de la première couche conductrice (253) de la porte ; et
une couche d'oxyde (231 ; 340) s'étend au-dessus de la STI (230) et sur une partie de la partie horizontale de la première couche conductrice (253) de la porte, et sous une partie correspondante de la pile de portes.

2. Cellule de mémoire vive selon la revendication 1,
**caractérisée en ce que**
la couche d'oxyde (240) s'étend de manière nominale à environ 1/3 de la largeur de la porte.

3. Système informatique, comprenant une mémoire utilisant la cellule de mémoire selon les revendications 1 ou 2.
